**Europäisches Patentamt**

**European Patent Office**

**Office européen des brevets**

(19)

(11) Veröffentlichungsnummer: **0 105 220**
**B1**

(12) **EUROPÄISCHE PATENTSCHRIFT**

(45) Veröffentlichungstag der Patentschrift:
**14.05.86**

(51) Int. Cl.⁴: **G 01 N 24/04,** G 01 N 24/08

(21) Anmeldenummer: **83108831.5**

(22) Anmeldetag: **07.09.83**

(54) Gerät zur Erzeugung von Bildern eines Untersuchungsobjektes mit magnetischer Kernresonanz.

(30) Priorität: **22.09.82 DE 3235113**

(43) Veröffentlichungstag der Anmeldung:
**11.04.84 Patentblatt 84/15**

(45) Bekanntmachung des Hinweises auf die Patenterteilung:
**14.05.86 Patentblatt 86/20**

(84) Benannte Vertragsstaaten:
**DE FR GB NL**

(56) Entgegenhaltungen:
**EP - A - 0 042 256**
**EP - A - 0 096 487**
**GB - A - 2 037 996**
**GB - A - 2 041 537**
**GB - A - 2 043 914**
**US - A - 3 501 688**
**US - A - 3 774 102**

(73) Patentinhaber: **Siemens Aktiengesellschaft, Berlin und München Wittelsbacherplatz 2, D-8000 München 2 (DE)**

(72) Erfinder: **Loeffler, Wilfried, Dr., Am Eichengarten 7, D-8522 Herzogenaurach (DE)**
Erfinder: **Oppelt, Arnulf, Dr., Am Eichergarten 7, D-8520 Erlangen (DE)**

**Beschreibung**

Die Erfindung betrifft ein Gerät zur Erzeugung von Bildern eines Untersuchungsobjektes mit magnetischer Kernresonanz, bei dem Spulen zum Anlegen von Magnetfeldern an das Untersuchungsobjekt und zum Erfassen der Auslenkung der Atomkerne des Untersuchungsobjektes aus ihrer Gleichgewichtslage durch einen hochfrequenten magnetischen Anregungsimpuls vorhanden sind.

Es ist bekannt, dass man insbesondere die Wasserstoffatomkerne eines Untersuchungsobjektes aus einer Vorzugsrichtung, die durch ein Magnet-Grundfeld erzeugt wird, durch einen hochfrequenten Anregungsimpuls auslenken kann und dass sich die Atomkerne nach dem Ende dieses Anregungsimpulses aufgrund ihres Spins erst nach einer gewissen Zeit wieder in die Vorzugsrichtung einpendeln. Während dieser Zeit präzedieren die Atomkerne mit einer Frequenz, die von der Stärke des Magnet-Grundfeldes abhängt. Überlagert man diesem homogenen Magnet-Grundfeld einen Feldgradienten, so dass die Magnetfeldverteilung räumlich variiert, so ist eine Ortung über die jeweils gemessene Frequenz möglich. Es ist auch bekannt, dass man auf diese Weise und durch Änderung der Richtung des Feldgradienten Schichtbilder des Untersuchungsobjektes anfertigen kann. Die Anregung in einer Schicht des Untersuchungsobjektes erfolgt dabei dadurch, dass das Magnet-Grundfeld durch einen weiteren Feldgradienten so beeinflusst wird, dass nur in dieser Schicht eine Anregung der Atomkerne erfolgt, weil die Anregung nur mit einer Frequenz erfolgt, die dem Magnetfeld in der gewünschten Schicht streng zugeordnet ist.

Mit Hilfe eines Gerätes der geschilderten Art sind grundsätzlich direkt messbar und bildlich darstellbar nur Grössen der Art

$$S = c \cdot f\,(\rho, T_1, T_2).$$

S ist dabei das gemessene Signal und f eine Funktion der bezeichneten Grössen, die je nach Messverfahren variiert. $\rho$ ist die Dichte und $T_1$, $T_2$ die Relaxationszeiten der angeregten Atomkerne. c ist eine Konstante, die die Empfindlichkeit der Apparatur kennzeichnet. Durch Normierung mehrerer mit unterschiedlichen Aufnahmeparametern aufgenommener Datensätze ist prinzipiell eine Berechnung absoluter Werte für $T_1$ und $T_2$ möglich. Es ist anzustreben, auch die direkt zugänglichen Grössen der Form S reproduzierbar und in einer für verschiedene Patienten gleichen Empfindlichkeit und damit Skalierung zu messen.

In der Praxis stehen diesem Wunsch eine Reihe zum Teil unvermeidlicher Effekte entgegen, die die Empfindlichkeit c des Messsystems beeinflussen und damit eine Reproduzierbarkeit und Übertragbarkeit der direkten Messwerte verhindern. Insbesondere bewirkt zum Beispiel die unterschiedliche Dämpfung der Empfangsspule bei Patienten mit verschiedenen Durchmessern eine solche unvermeidliche Änderung der Empfindlichkeit des Messsystems. Auch eine Berechnung absoluter Werte für $T_1$ und $T_2$ wird vielfach in der Praxis aufgrund einer von Patient zu Patient variierenden Dämpfung der Sendeimpulse mit der Folge unkorrekter Hochfrequenz-Impulse fehlerhaft sein.

Zur Normierung ist es bereits bekannt, bei einem Gerät der eingangs genannten Art einen Eichkörper bekannter Zusammensetzung vorzusehen, anhand dessen eine Eichmessung vorgenommen werden kann (GB-A-20 43 914). Dieser bekannte Eichkörper eignet sich jedoch nicht zur Verwendung in Verbindung mit der Untersuchung eines Patienten, d.h. der gleichzeitigen Messung am Patienten und am Eichkörper. Es ist ferner bekannt, in einem Gerät der eingangs genannten Art sowohl eine zu untersuchende Probe als auch eine Eichprobe vorzusehen (US-A-35 01 688). Bei dem bekannten Gerät ist jedoch die Untersuchung von Patienten und damit auch eine Eichmessung bei gleichzeitiger Messung am Patienten nicht vorgesehen.

Zweck der vorliegenden Erfindung ist es, eine Möglichkeit zur Normierung und damit zum Ausgleich der unterschiedlichen Empfindlichkeit der Empfangsspule und Dämpfung der Sendespule bei einem Gerät der eingangs genannten Art für die Untersuchung von Patienten zu schaffen.

Diese Aufgabe ist erfindungsgemäss dadurch gelöst, dass der Eichkörper so ausgebildet ist, dass er das Untersuchungsobjekt bei der Messung mindestens teilweise aussen umgreift, so dass er bei der Messung bei jeder gewählten Bildebene von dieser mindestens teilweise geschnitten wird. Bei dem erfindungsgemässen Gerät ist ein Eichkörper mit definierten Werten von $\rho$, $T_1$ und $T_2$ am Rand des Messfeldes angebracht, so dass eine simultane Messung der untersuchten Schicht und des Eichkörpers und damit eine Normierung der empfangenen Signale möglich ist.

Ein Eichkörper besteht zweckmässigerweise aus wässrigen Lösungen eines paramagnetischen Salzes, über dessen Konzentration eine gewebsähnliche Relaxationszeit eingestellt werden kann. Die Lösungen befinden sich vorzugsweise in fest verschlossenen Glasgefässen, um eine Verdunstung des Wassers und damit eine Konzentrationsänderung zu verhindern.

Die Korrektur der Messwerte erfolgt im Hinblick auf variierende Empfängerempfindlichkeit in vorteilhafter Weise derart, dass das gemessene Signal aus dem Bereich des Eichkörpers als Mass für die Empfindlichkeit des Systems dient und alle Messwerte aus dem Bereich des Aufnahmeobjektes mit einem entsprechenden Faktor auf eine konstante Empfindlichkeit umgerechnet werden.

Die Erfindung ist nachfolgend anhand eines in der Zeichnung dargestellten Ausführungsbeispieles näher erläutert. Es zeigen:

Fig. 1 eine Darstellung eines Gerätes zur Erzeugung von Bildern mit magnetischer Kernresonanz zur Erläuterung des Erfindungsgedankens,

Fig. 2 einen bei dem Gerät gemäss Fig. 1 anwendbaren Eichkörper, und

Fig. 3, 4 und 5 Varianten solcher Eichkörper.

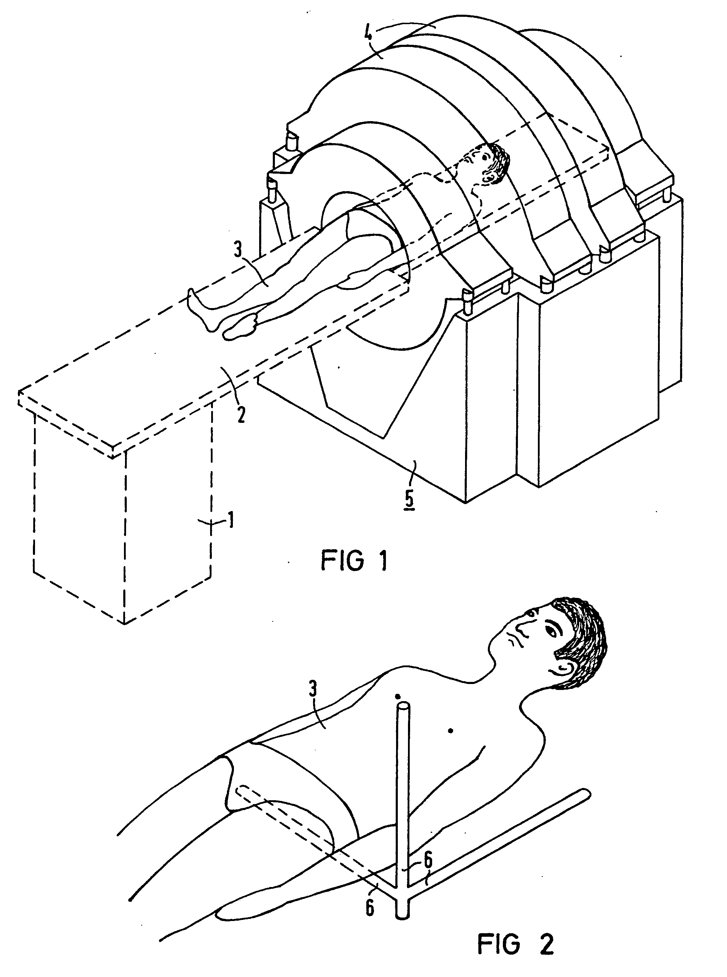

In der Figur 1 ist eine auf einem Sockel 1 gelagerte Patientenliege 2 mit einem Patienten 3 dargestellt, der im Innern von Spulen 4 eines Gerätes zur Erzeugung von Bildern eines Untersuchungsobjektes mit magnetischer Kernresonanz liegt. Die Spulen 4 dienen zum Anlegen von Magnetfeldern an den Patienten 3 und zum Erfassen der Auslenkung der Atomkerne des Patienten 3 aus ihrer Gleichgewichtslage durch einen hochfrequenten magnetischen Anregungsimpuls. Sie sind an einem Sockel 5 befestigt.

Die Figur 2 zeigt, dass im Innern der Spulen 4 ein Eichkörper 6 so angeordnet ist, dass er bei der Messung des Patienten 3 bei jeder gewählten Bildebene von dieser mindestens teilweise geschnitten wird. Der Eichkörper 6 besteht aus drei flüssigkeitsgefüllten, geraden, zylindrischen Glasröhren, die im rechten Winkel zueinander angeordnet sind. Dadurch ist für axiale, koronare und sagittale Schichten gewährleistet, dass immer ein Glasrohr durch die untersuchte Ebene geschnitten wird.

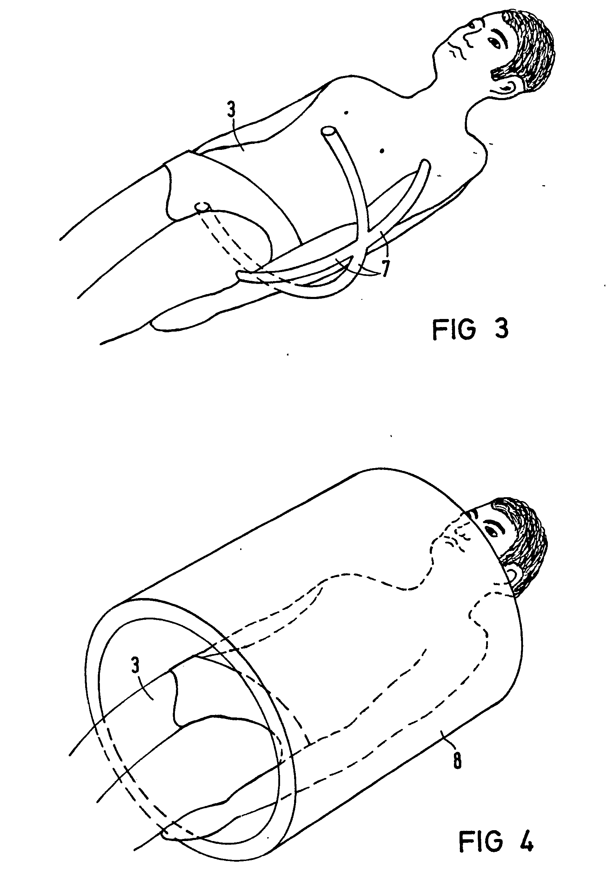

Der in Figur 3 gezeigte Eichkörper 7 besteht aus drei flüssigkeitsgefüllten gebogenen Glasröhren mit kreisförmigem Querschnitt und passt sich dem kugelförmigen ausnutzbaren Messvolumen der Spulen 4 an. Die durch die drei gebogenen Rohre aufgespannten Ebenen stehen senkrecht aufeinander. Es ist so auch bei Schichtorientierungen, die gegenüber den axialen, koronaren und sagittalen Ebenen verdreht sind, gewährleistet, dass am Rande des untersuchten Messfeldes immer ein Glasrohr des Eichkörpers ausgeschnitten und damit mitgemessen wird.

Die Figur 4 zeigt einen Eichkörper 8 in Form eines flüssigkeitsgefüllten, doppelwandigen, zylindrischen Rohres. Auch hierdurch wird sichergestellt, dass für alle Schichtorientierungen Bereiche des Eichkörpers mitgemessen werden und so zur Normierung dienen können.

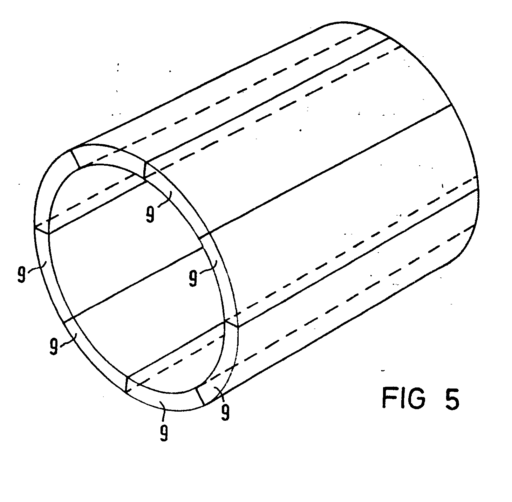

Zur Korrektur der Auswirkungen der variierenden Dämpfung der Sendespule und der resultierenden Fehler der Hochfrequenz-Impulse muss die spezielle verwendete Messfrequenz berücksichtigt werden. Es sind die Auswirkungen dieser Fehler auf die funktionelle Abhängigkeit f, die für jede Messsequenz anders sind, zu untersuchen und geeignete Korrekturverfahren zu implementieren. Dies ist möglich, da die Messwerte des Eichkörpers eine Berechnung der Sendespulendämpfung erlauben. Unter Umständen ist es dabei nötig, eine Unterteilung des Eichkörpers in mehrere Kammern 9 vorzusehen (Fig. 5), die Substanzen mit unterschiedlichen Werten für $\rho$, $T_1$ und $T_2$ enthalten, um eine experimentelle Trennung der Empfänger- und Sendespulendämpfung zu erlauben.

Ein weiterer Vorteil der erfindungsgemässen Anordnung eines Eichkörpers im Messfeld besteht darin, dass in den Untersuchungspausen, in denen kein Patient in der Messapparatur liegt, ebenfalls ein Kernresonanzsignal gemessen werden kann, um beispielsweise die Stärke des Magnetfeldes entsprechend nachzuregeln. Die Ausführung des Eichkörpers nach Figur 2 erlaubt es zusätzlich zu unterscheiden, welche Aufsicht auf die ausgemessene Schicht dargestellt ist (von vorne, hinten, oben, unten, rechts oder links).

## Patentanspruch

1. Gerät zur Erzeugung von Bildern eines Untersuchungsobjektes (3) mit magnetischer Kernresonanz, bei dem Spulen (4) zum Anlegen von Magnetfeldern an das Untersuchungsobjekt (3) und zum Erfassen der Auslenkung der Atomkerne des Untersuchungsjektes (3) aus ihrer Gleichgewichtslage durch einen hochfrequenten magnetischen Anregungsimpuls vorhanden sind, wobei in den Spulen (4) mindestens ein Eichkörper (6 bis 9) bekannter Zusammensetzung angebracht ist, dadurch gekennzeichnet, dass der Eichkörper (6 bis 9) so ausgebildet ist, dass er das Untersuchungsobjekt (3) bei der Messung mindestens teilweise aussen umgreift, so dass er bei der Messung bei jeder gewählten Bildebene von dieser mindestens teilweise geschnitten wird.

## Claim

1. Apparatus for producing images of an object under examination (3) using nuclear magnetic resonance, in which there are provided coils (4) for applying magnetic fields to the object under examination (3) and for detecting the deflection of the atomic nuclei of the object under examination (3) from their equilibrium position by means of a highfrequency magnetic excitation pulse, where at least one calibration body (6 to 9) of known composition is mounted in the coils (4), characterised in that the calibration body (6 to 9) is so formed that, during the measurement, it partially surrounds the object under examination (3) from the outside, so that, during the measurement, for each selected image plane, it is partially intersected by the latter.

## Revendication

1. Appareil pour produire des images d'un objet examiné (3) par résonance magnétique nucléaire (RMN), comprenant des bobines (4) pour appliquer des champs magnétiques à l'objet examiné (3) et pour détecter la déviation des noyaux atomiques de l'objet examiné (3) de leur position d'équilibre par une impulsion magnétique d'excitation à haute fréquence, avec disposition d'au moins un corps étalon (6 à 9) de composition connue dans les bobines (4), caractérisé en ce que le corps étalon (6 à 9) est conformé de sorte qu'il entoure l'objet examiné (3) extérieurement en partie au moins lors de la mesure, de manière que, lors de la mesure, à chaque plan d'image choisi, il soit coupé au moins partiellement par celui-ci.

FIG 1

FIG 2

FIG 3

FIG 4

FIG 5